# EUROPEAN PATENT APPLICATION

(11) **EP 4 044 259 A1**
(43) Date of publication of application: **17.08.2022**
(21) Application number: 21751493.4
(22) Date of filing: 27.04.2021
(51) Int. Cl.: H01L 31/0376, H01L 31/072

(54) **EFFICIENT HETEROJUNCTION BATTERY STRUCTURE AND PREPARATION METHOD THEREFOR**

(30) Priority: 28.12.2020 CN 202011606801
(71) Applicant: Suzhou Talesun Solar Technologies Co., Ltd., Suzhou, Jiangsu 215542 (CN)
(72) Inventor: ZHANG, Shude, Changshu Jiangsu 215500 (CN); ZHAO, Baoxing, Changshu Jiangsu 215500 (CN); NI, Zhichun, Changshu Jiangsu 215500 (CN); LIAN, Weifei, Changshu Jiangsu 215500 (CN); WEI, Qingzhu, Changshu Jiangsu 215500 (CN); FU, Xin, Changshu Jiangsu 215500 (CN)
(74) Representative: Kolster Oy Ab
(86) International application number: PCT/CN2021/090278
(87) International publication number: WO 2022/142007

(57) **Abstract**

The application relates to a high-efficiency heterojunction cell structure and a preparation method thereof. The high-efficiency heterojunction cell structure includes a bottom electrode, a back transparent conductive film layer, an n-type doped amorphous silicon layer, a back intrinsic amorphous silicon layer, a back intrinsic amorphous silicon buffer layer, an n-type monocrystal silicon wafer, a front intrinsic amorphous silicon buffer layer, a front intrinsic amorphous silicon layer, a p-type doped amorphous silicon layer, a front transparent conductive film layer and a top electrode which are sequentially arranged from bottom to top. The high-efficiency heterojunction cell structure and the preparation method thereof greatly improve the definition of an amorphous silicon/silicon substrate interface, improve the passivation effect, and further improve the open circuit voltage of the cell and the filling factor related to the open circuit voltage.

## Description

The present application claims priority to the Chinese patent application No. 202011606801.4, entitled "High-efficiency heterojunction cell structure and preparation method thereof", filed in the China National Intellectual Property Administration on December 28, 2020, which is incorporated herein by reference in its entirety.

### FIELD OF THE PRESENT DISCLOSURE

The invention relates to a high-efficiency heterojunction cell structure and a preparation method thereof, belonging to the field of solar cell preparation.

### BACKGROUND OF THE PRESENT DISCLOSURE

At present, the mass production efficiency of the industrial PERC cell is continuously improved, and gradually approaches the conversion efficiency limit. The conversion efficiency of the mass production cell is based on a solar cell with a heterojunction structure, the front surface of the existing heterojunction cell structure is basically a doped amorphous silicon/intrinsic amorphous silicon layer/silicon base structure, and the structure and preparation process of the intrinsic amorphous silicon layer are very important. In order to obtain an optimal passivation effect, the PECVD plasma energy will be decreased in the deposition process of the intrinsic amorphous silicon layer so as to reduce the deposition rate and the bombardment effect of the plasma on the substrate surface. However, when the deposition rate is reduced, the non-uniform epitaxial growth of the amorphous silicon on the surface of the silicon can occur, and the epitaxial growth will greatly reduce the passivation quality of the intrinsic amorphous silicon layer and further lower the passivation effect. Therefore, in the preparation process of the heterojunction cell, the deposition process of the intrinsic amorphous silicon layer needs to be finely adjusted so as to balance the contradiction between those two.

According to the existing heterojunction cell, carrier selective contact is formed by doped amorphous silicon/intrinsic amorphous silicon/silicon wafer. On one hand, the main function of the intrinsic amorphous silicon layer is a passivation effect, and in order to obtain a better passivation effect, it is necessary to lower energy as much as possible during the deposition, and the deposition rate is decreased to ensure more hydrogen doping and less plasma bombardment damage; on the other hand, when the deposition energy is reduced, epitaxial growth is easily caused at the amorphous silicon/silicon interface, and the epitaxial growth will reduce the quality of the amorphous silicon and the hydrogen content in the amorphous silicon. There is a trade-off contradiction between the passivation performance and the quality of the film layer itself, which is difficult to balance.

### SUMMARY OF THE PRESENT DISCLOSURE

The object of the invention is to provide a high-efficiency heterojunction cell structure and the preparation method thereof, dramatically improving the definition of an amorphous silicon/silicon substrate interface, improving the passivation effect, and further improving the open circuit voltage of the cell and the filling factor related to the open circuit voltage.

To accomplish the object, the invention provides a technical solution as follows: a high-efficiency heterojunction cell structure, comprising a bottom electrode, a back transparent conductive film layer, an n-type doped amorphous silicon layer, a back intrinsic amorphous silicon layer, a back intrinsic amorphous silicon buffer layer, an n-type monocrystal silicon wafer, a front intrinsic amorphous silicon buffer layer, a front intrinsic amorphous silicon layer, a p-type doped amorphous silicon layer, a front transparent conductive film layer and a top electrode which are sequentially arranged from bottom to top, wherein the deposition energy and deposition rate of the back intrinsic amorphous silicon buffer layer are smaller than those of the back intrinsic amorphous silicon layer, and the deposition energy and the deposition rate of the front intrinsic amorphous silicon buffer layer are smaller than those of the front intrinsic amorphous silicon layer.

Further, the bottom electrode and top electrode are each independently selected from one or more of gold, silver, copper, or aluminum electrodes.

Further, the back transparent conductive film layer and the front transparent conductive film layer are each independently selected from one or more of zinc oxide, indium oxide, titanium oxide or tungsten oxide.

Further, in the n-type doped amorphous silicon layer, the doping element is a phosphorus element; and/or the thickness of the n-type doped amorphous silicon layer is 1-15nm.

Further, in the p-type doped amorphous silicon layer, the doping element is one or more of boron, aluminum or gallium elements; and/or the thickness of the p-type doped amorphous silicon layer is 1-15nm.

Further, the thickness of the back intrinsic amorphous silicon buffer layer and the front intrinsic amorphous silicon buffer layer is 0.5-1.5nm.

Further, the thickness of the back intrinsic amorphous silicon layer and the front intrinsic amorphous silicon layer is 5-8nm.

The application also provides a preparation method of the high-efficiency heterojunction cell structure, which includes the following steps:
S1, providing a silicon wafer, and texturing the silicon wafer;
S2, sequentially depositing a front intrinsic amorphous silicon buffer layer and a front intrinsic amorphous silicon layer on a front side of the silicon wafer;
S3, depositing a p-type doped amorphous silicon layer on the front intrinsic amorphous silicon layer after plasma treatment;
S4, after plasma treatment, sequentially depositing a back intrinsic amorphous silicon buffer layer and a back intrinsic amorphous silicon layer on a back side of the silicon wafer;
S5, after plasma treatment, depositing an n-type doped amorphous silicon layer on the back intrinsic amorphous silicon layer;
and S6, after plasma treatment, depositing a transparent conductive film layer on two sides of the silicon wafer, and providing an electrode on the transparent conductive film layer.

Further, the deposition rate of the front intrinsic amorphous silicon buffer layer and the back intrinsic amorphous silicon buffer layer is ≤2 angstroms/s, which are deposited by means of an RF radio-frequency power supply, wherein the plasma frequency is 13.56MHz, a temperature is 100-250 °C , the deposition pressure is ≤0.7mbar, the deposition power density is ≤20mW/cm², the silane flow is 0.4-1.0sccm, the hydrogen flow is 80-160sccm; and/or the front intrinsic amorphous silicon layer and the back intrinsic amorphous silicon layer are deposited according to PECVD method, wherein the plasma frequency is 40.68MHz, the temperature is 100-250°C, the deposition intensity of pressure is 2.8-5.5mbar, the deposition power density is 40-80mW/cm², the silane flow is 0.4-1.0sccm, the hydrogen flow is 80-160sccm, and the deposition thickness is 5-8nm.

Further, the plasma treatment is performed according to a PECVD method, wherein the plasma frequency is 13.56MHz, the temperature is 100-250°C, the deposition intensity of pressure is 1.8-3.5mbar, the deposition power density is 40-80mW/cm², the hydrogen flow is 100-300sccm, and the treatment time is 20s-600s; and/or the processing power for the front intrinsic amorphous silicon layer and the back intrinsic amorphous silicon layer is greater than the processing power for the p-type doped amorphous silicon layer and the n-type doped amorphous silicon layer; and/or the processing power for the front intrinsic amorphous silicon layer is greater than the processing power for the back intrinsic amorphous silicon layer.

Further, the p-type doped amorphous silicon layer is deposited according to the PECVD method, wherein the plasma frequency is 13.56MHz, the temperature is 100-250°C, the deposition intensity of pressure is 1.8-5.5mbar, the deposition power density is 40-100mW/cm², the silane flow is 0.5-1.5sccm, the hydrogen flow is 50-300sccm, and the borane flow is 5-30sccm.

Further, the n-type doped amorphous silicon layer is deposited according to the PECVD method, wherein by adopting the PECVD method, the plasma frequency is 13.56MHz, the temperature is 100-250°C, the deposition intensity of pressure is 1.8-5.5mbar, the deposition power density is 40-100mW/cm², the silane flow is 0.5-1.5sccm, the hydrogen flow is 50-300sccm, carbon dioxide flow is 0-5sccm, and phosphorane flow is 0.5-4sccm.

As compared with the prior art, the invention has the advantageous effects as follows: according to the high-efficiency heterojunction cell structure and the preparation method thereof provided by this application, the intrinsic amorphous silicon layer is separated into two layers: one layer is a conventional amorphous silicon layer, while the other layer is an intrinsic amorphous silicon buffer layer deposited at an ultra-low speed. The structure and the process greatly improve the definition of an amorphous silicon/silicon substrate interface, improve the passivation effect, and further improve the open circuit voltage of the cell and the filling factor related to the open circuit voltage.

The above description is only an overview of the technical solution of the present invention. In order to understand the technical means of the present invention more clearly and implement it in accordance with the content of the description, the preferred embodiments of the present invention will be described in detail below in conjunction with the accompanying drawings.

### BRIEF DESCRIPTION OF THE DRAWINGS

Fig. 1 is a schematic diagram showing a structure of a high-efficiency heterojunction cell structure shown in an embodiment of the present application;
Fig. 2 is a schematic diagram showing a three-dimensional structure of a high-efficiency heterojunction cell structure shown in an embodiment of the application.

### DESCRIPTION OF THE EMBODIMENTS

The specific preferred embodiments of the present invention will be described in further detail below in conjunction with the accompanying drawings and embodiments. The following embodiments are intended to illustrate the invention, but not to limit the scope thereof.

It should be noted that the terms "upper", "lower", "left", "right", "inner", "outer" and the likes in the present invention are only illustrative rather than restrictive, to describe the present invention with reference to the drawings.

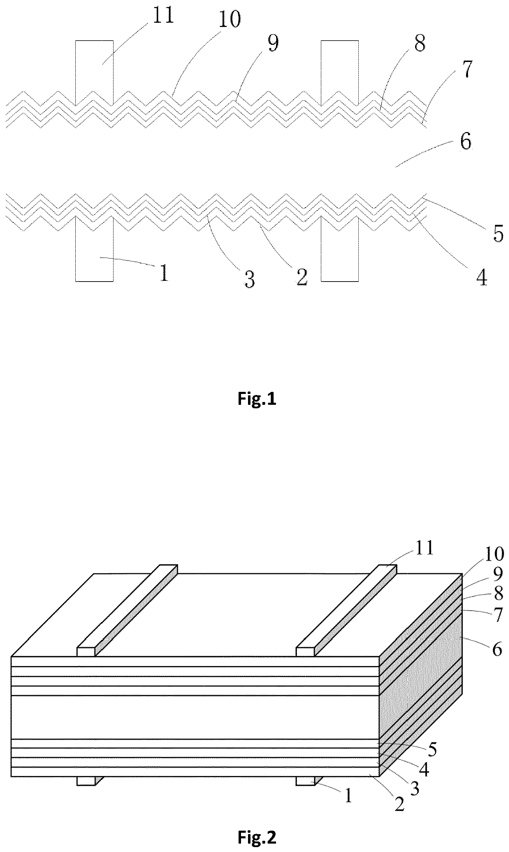

Referring to Fig. 1 and Fig. 2, a high-efficiency heterojunction cell structure according to an embodiment of the present application includes a bottom electrode 1, a back transparent conductive film layer 2, an n-type doped amorphous silicon layer 3, a back intrinsic amorphous silicon layer 4, a back intrinsic amorphous silicon buffer layer 5, an n-type monocrystal silicon wafer 6, a front intrinsic amorphous silicon buffer layer 7, a front intrinsic amorphous silicon layer 8, a p-type doped amorphous silicon layer 9, a front transparent conductive film layer 10 and a top electrode 11 which are sequentially arranged from bottom to top, wherein the deposition energy and the deposition rate of the back intrinsic amorphous silicon buffer layer 5 are smaller than the deposition energy and the deposition rate of the back intrinsic amorphous silicon layer 4, and the deposition energy and the deposition rate of the front intrinsic amorphous silicon buffer layer 7 are smaller than the deposition energy and the deposition rate of the front intrinsic amorphous silicon layer 8.

Specifically, the bottom electrode 1 and the top electrode 11 can be one or more of gold, silver, copper, and aluminum; the back transparent conductive film layer 2 and the front transparent conductive film layer 10 can be a layer formed by one or more metal oxides among zinc oxide, indium oxide, titanium oxide, tungsten oxide and the like. The back transparent conductive film layer 2 and the front transparent conductive film layer 10 can allow light to pass through while conducting electricity so as to enable light energy to be converted into electric energy under the action of the n-type doped amorphous silicon layer 3, the back intrinsic amorphous silicon layer 4, the back intrinsic amorphous silicon buffer layer 5, the n-type monocrystal silicon wafer 6, the front intrinsic amorphous silicon buffer layer 7, the front intrinsic amorphous silicon layer 8 and the p-type doped amorphous silicon layer 9; the n-type doped amorphous silicon layer 3 is a hydrogenated amorphous silicon layer, the doping elements are phosphorus elements and the likes, and the thickness is 1-15nm; the p-type doped amorphous silicon layer 9 is a hydrogenated amorphous silicon layer, the doping elements are one or more of boron, aluminum, gallium and other elements, and the thickness is 1-15nm; the thickness of the back intrinsic amorphous silicon layer 4 and the front intrinsic amorphous silicon layer 8 is 5-8nm; the thickness of the back intrinsic amorphous silicon buffer layer 5 and the front intrinsic amorphous silicon buffer layer 7 is 0.5-1.5nm.

The implementation aspect of the process is described in detail as follows.

Texturing →- Front intrinsic amorphous silicon buffer layer deposition →-Front intrinsic amorphous silicon deposition →- Hydrogen plasma treatment →- p-type doped hydrogenated amorphous silicon deposition →- Hydrogen plasma treatment →- Back intrinsic amorphous silicon buffer layer deposition → Back Intrinsic amorphous silicon deposition →- Hydrogen plasma treatment → n-type doped hydrogenated amorphous silicon deposition →- Hydrogen plasma treatment →- Front TCO deposition → Back TCO deposition →- Front and back screen printing metallization pattern → Curing.

The steps of a specific embodiment are as follows.

Step 1: texturing: an n-type silicon wafer is provided, and texturing is carried out on a silicon wafer by employing a KOH solution to prepare a textured structure with the edge length of 1-10µm of a pyramid base.

Step 2: front intrinsic amorphous silicon buffer layer deposition: depositing it according to PECVD method, where the plasma frequency is 13.56MHz, the temperature is 100-250°C, the deposition intensity of pressure is 0.2-0.7mbar, the deposition power density is 5-20mW/cm², the silane flow is 0.4-1.0sccm, the hydrogen flow is 80-160sccm, and the deposition thickness is 0.5-1.5nm. Because the front intrinsic amorphous silicon buffer layer has lower deposition energy and deposition rate than the front intrinsic amorphous silicon, when the front intrinsic amorphous silicon buffer layer is deposited on the silicon wafer, the bombardment damage of the plasma to the surface of the silicon wafer can be reduced, and meanwhile, the hydrogen content of the front intrinsic amorphous silicon buffer layer can be increased, the dangling bond within the silicon surface is saturated, and the density of the defect state on the surface of the silicon wafer is reduced.

Step 3: front intrinsic amorphous silicon deposition: depositing it according to PECVD method, where the plasma frequency is 40.68MHz, the temperature is 100-250°C, the deposition intensity of pressure is 2.8-5.5mbar, the deposition power density is 40-80mW/cm², the silane flow is 0.4-1.0sccm, the hydrogen flow is 80-160sccm, and the deposition thickness is 5-8nm.

Step 4: hydrogen plasma treatment 1: adopting a PECVD method, wherein the plasma frequency is 13.56MHz, the temperature is 100-250°C, the deposition intensity of pressure is 1.8-3.5mbar, the deposition power density is 40-80mW/cm², the hydrogen flow is 100-300sccm, and the treatment time is 20s-600s.

Step 5: p-type doped hydrogenated amorphous silicon deposition: adopting a PECVD method, wherein the plasma frequency is 13.56MHz, the temperature is 100-250°C, the deposition intensity of pressure is 1.8-5.5mbar, the deposition power density is 40-100mW/cm², the silane flow is 0.5-1.5sccm, the hydrogen flow is 50-300sccm, the borane (hydrogen carrier) flow is 5-30sccm, and the deposition thickness is 1-5nm.

Step 6: hydrogen plasma treatment 2: adopting a PECVD method, wherein the plasma frequency is 13.56MHz, the temperature is 100-250°C, the deposition intensity of pressure is 1.8-3.5mbar, the deposition power density is 40-80mW/cm² (the power is less than that of the hydrogen plasma treatment 1), and the hydrogen flow is 100-300sccm.

Step 7: back intrinsic amorphous silicon buffer layer deposition: depositing it according to PECVD method, wherein the plasma frequency is 13.56MHz, the temperature is 100-250°C, the deposition intensity of pressure is 0.2-0.7mbar, the deposition power density is 5-20mW/cm², the silane flow is 0.4-1.0sccm, the hydrogen flow is 80-160sccm, and the deposition thickness is 0.5-1.5nm. Because the back intrinsic amorphous silicon buffer layer has lower deposition energy and deposition rate than the back intrinsic amorphous silicon, when the back intrinsic amorphous silicon buffer layer is deposited on the silicon wafer, the bombardment damage of the plasma to the surface of the silicon wafer can be reduced, and meanwhile, the hydrogen content of the back intrinsic amorphous silicon buffer layer can be increased, the dangling bond within the silicon surface is saturated, and the density of the defect state on the surface of the silicon wafer is reduced.

Step 8: back intrinsic amorphous silicon deposition: depositing it according to PECVD method, wherein the plasma frequency is 40.68MHz, the temperature is 100-250°C, the deposition intensity of pressure is 2.8-5.5mbar, the deposition power density is 40-80mW/cm², the silane flow is 0.4-1.0sccm, the hydrogen flow is 80-160sccm, and the deposition thickness is 5-8nm.

Step 9: hydrogen plasma treatment 3: adopting a PECVD method, wherein the plasma frequency is 13.56MHz, the temperature is 100-250°C, the deposition intensity of pressure is 1.8-3.5mbar, the deposition power density is 40-80mW/cm², and the hydrogen flow is 100-300sccm.

Step 10: n-type doped hydrogenated amorphous silicon deposition: adopting a PECVD method, wherein the plasma frequency is 13.56MHz, the temperature is 100-250°C, the deposition intensity of pressure is 1.8-5.5mbar, the deposition power density is 40-100mW/cm², the silane flow is 0.5-1.5sccm, the hydrogen flow is 50-300sccm, the carbon dioxide flow is 0-5sccm, the phosphane (hydrogen carrier) flow is 0.5-4sccm, and the deposition thickness is 10-20nm.

Step 11: hydrogen plasma treatment 4: adopting a PECVD method, wherein the plasma frequency is 13.56MHz, the temperature is 100-250 °C, the deposition intensity of pressure is 1.8-3.5mbar, the deposition power density is 40-80mW/cm² (the power is less than the hydrogen plasma treatment 3), and the hydrogen flow is 100-300sccm.

Step 12: TCO deposition: the transparent conductive film layer is deposited on both sides according to a PVD method or an RPD method.

Step 13: screen printing: the front and back sides of cells are screen printed and curing is carried out.

In the embodiment, the key point of the process is that the original process and deposition rate are still maintained in depositing the intrinsic amorphous silicon layer. Before depositing the intrinsic amorphous silicon layer, one layer of the intrinsic amorphous silicon buffer layer is deposited. The deposition rate of the buffer layer is lower than the deposition rate of the intrinsic amorphous silicon, the deposition rate is ≤2 angstroms/s, the deposition temperature is about 220°C which is the same as that of the intrinsic layer, the deposition pressure is about 0.7mbar which is lower than that of the intrinsic layer, and the deposition power is 0.5-0.75 times of that of the intrinsic layer. In the process aspect, hydrogen plasma treatment is adopted before and after the doped hydrogenated amorphous silicon layer is deposited, and the deposition rate of the intrinsic buffer layer is lower than that of the intrinsic layer so that a better passivation effect can be realized.

To sum up, according to the high-efficiency heterojunction cell structure and the preparation method thereof provided by the application, the intrinsic amorphous silicon layer is separated into two layers: one layer is a conventional amorphous silicon layer, and the other layer is an intrinsic amorphous silicon buffer layer deposited at an ultra-low speed. The structure and the process greatly improve the definition of an amorphous silicon/silicon substrate interface, improve the passivation effect, and further improve the open circuit voltage of the cell and the filling factor related to the open circuit voltage.

Each of technical features of the above-mentioned embodiments can be combined in any combination, and for sake of the conciseness of the description, not all possible combinations of teach of technical features of the above-mentioned embodiments are described. However, as long as there is no contradiction between these combinations of technical features, they should be considered to be encompassed within the scope of the description.

The foregoing embodiments are illustrative of only a few preferred embodiments of the invention, and are described in specific detail and are in no way to be restrictive for the scope of the patent for invention. It should be pointed out that for those of ordinary skill in the art, without departing from the concept of the present invention, several modifications and improvements can be made, which all fall within the protection scope of the present invention. Therefore, the protection scope of the patent for invention shall be determined by the appended claims.

## Claims

1. A high-efficiency heterojunction cell structure, **characterized by** comprising a bottom electrode, a back transparent conductive film layer, an n-type doped amorphous silicon layer, a back intrinsic amorphous silicon layer, a back intrinsic amorphous silicon buffer layer, an n-type monocrystal silicon wafer, a front intrinsic amorphous silicon buffer layer, a front intrinsic amorphous silicon layer, a p-type doped amorphous silicon layer, a front transparent conductive film layer and a top electrode, which are sequentially arranged from bottom to top, wherein deposition energy and deposition rate of the back intrinsic amorphous silicon buffer layer are smaller than those of the back intrinsic amorphous silicon layer, and the deposition energy and the deposition rate of the front intrinsic amorphous silicon buffer layer are smaller than those of the front intrinsic amorphous silicon layer.

2. The high-efficiency heterojunction cell structure according to claim 1, **characterized in that** the bottom electrode and the top electrode are each independently selected from one or more of gold, silver, copper or aluminum electrodes; the back transparent conductive film layer and the front transparent conductive film layer are each independently selected from one or more of zinc oxide, indium oxide, titanium oxide or tungsten oxide.

3. The high-efficiency heterojunction cell structure according to claim 1, **characterized in that** in the n-type doped amorphous silicon layer, the doping element is a phosphorus element; in the p-type doped amorphous silicon layer, the doping element is one or more of boron, aluminum or gallium elements; a thickness of the n-type doped amorphous silicon layer is 1-15 nm; the thickness of the p-type doped amorphous silicon layer is 1-15 nm.

4. The high-efficiency heterojunction cell structure according to claim 1, **characterized in that** the thickness of the back intrinsic amorphous silicon buffer layer and the front intrinsic amorphous silicon buffer layer is 0.5-1.5 nm; the thickness of the back intrinsic amorphous silicon layer and the front intrinsic amorphous silicon layer is 5-8 nm.

5. A preparation method for the high-efficiency heterojunction cell structure according to any one of claims 1 to 4, comprising the following steps:
S1, providing a silicon wafer, and texturing the silicon wafer;
S2, sequentially depositing a front intrinsic amorphous silicon buffer layer and a front intrinsic amorphous silicon layer on a front side of the silicon wafer;
S3, depositing a p-type doped amorphous silicon layer on the front intrinsic amorphous silicon layer after plasma treatment;
S4, after the plasma treatment, sequentially depositing a back intrinsic amorphous silicon buffer layer and a back intrinsic amorphous silicon layer on a back side of the silicon wafer;
S5, after the plasma treatment, depositing an n-type doped amorphous silicon layer on the back intrinsic amorphous silicon layer;
and S6, after the plasma treatment, depositing a transparent conductive film layer on two sides of the silicon wafer, and providing an electrode on the transparent conductive film layer.

6. The preparation method according to claim 5, **characterized in that** deposition rate of the front intrinsic amorphous silicon buffer layer and the back intrinsic amorphous silicon buffer layer is ≤2 angstroms/s, which are deposited by means of an RF radio-frequency power supply, wherein plasma frequency is 13.56MHz, a temperature is 100-250°C, deposition pressure is ≤0.7mbar, deposition power density is ≤20mW/cm², silane flow is 0.4-1.0sccm, hydrogen flow is 80-160sccm; and/or the front intrinsic amorphous silicon layer and the back intrinsic amorphous silicon layer are deposited according to PECVD method, wherein the plasma frequency is 40.68MHz, the temperature is 100-250°C, deposition intensity of pressure is 2.8-5.5mbar, the deposition power density is 40-80mW/cm², the silane flow is 0.4-1.0sccm, the hydrogen flow is 80-160sccm, and deposition thickness is 5-8nm.

7. The preparation method according to claim 5, **characterized in that** the plasma treatment is performed according to a PECVD method, wherein the plasma frequency is 13.56MHz, the temperature is 100-250°C, the deposition intensity of pressure is 1.8-3.5mbar, the deposition power density is 40-80mW/cm², the hydrogen flow is 100-300sccm, and treatment time is 20s-600s; and/or processing power for the front intrinsic amorphous silicon layer and the back intrinsic amorphous silicon layer is greater than the processing power for the p-type doped amorphous silicon layer and the n-type doped amorphous silicon layer; and/or the processing power for the front intrinsic amorphous silicon layer is greater than the processing power for the back intrinsic amorphous silicon layer.

8. The preparation method according to claim 5, **characterized in that** the p-type doped amorphous silicon layer is deposited according to the PECVD method, wherein the plasma frequency is 13.56MHz, the temperature is 100-250 °C, the deposition intensity of pressure is 1.8-5.5mbar, the deposition power density is 40-100mW/cm², the silane flow is 0.5-1.5sccm, the hydrogen flow is 50-300sccm, and the borane flow is 5-30sccm.

9. The preparation method according to claim 5, **characterized in that** the n-type doped amorphous silicon layer is deposited according to the PECVD method, wherein by adopting the PECVD method, the plasma frequency is 13.56MHz, the temperature is 100-250°C, the deposition intensity of pressure is 1.8-5.5mbar, the deposition power density is 40-100mW/cm², the silane flow is 0.5-1.5sccm, the hydrogen flow is 50-300sccm, carbon dioxide flow is 0-5sccm, and phosphorane flow is 0.5-4sccm.
